# EUROPEAN PATENT APPLICATION

(11) **EP 3 503 220 A2**
(43) Date of publication of application: **26.06.2019**
(21) Application number: 18188139.2
(22) Date of filing: 09.08.2018
(51) Int. Cl.: H01L 31/18, H01L 21/677, H01L 21/683, H01L 21/67

(54) **DEVICE AND METHOD FOR TURNING CELL OVER**

(30) Priority: 22.12.2017 CN 201711404936
(71) Applicant: Beijing Juntai Innovation Technology Co., Ltd, 100176 Beijing (CN)
(72) Inventor: YANG, Bin, Beijing, Beijing 100176 (CN)
(74) Representative: Cohausz & Florack

(57) **Abstract**

The present disclosure provides a device (10) and a method for turning a cell over. The device (10) for turning a cell over includes a turnover mechanism (20) and a loading mechanism (30), wherein the turnover mechanism (20) includes a first gantry (200) that is slidably disposed, and the first gantry (200) is configured to pick up and turn over a cell (600); the loading mechanism (30) includes a second gantry (300) that is slidably disposed, and the second gantry (300) is configured to pick up and load the cell (600) that is turned over by the first gantry (200).

## Description

### CROSS-REFERENCE TO RELATED APPLICATIONS

This international application claims priority of invention patent application No. 201711404936.0 filed on December 22, 2017 with State Intellectual Property Office in China, the entirety of which are incorporated herein by reference.

### FIELD

The present disclosure relates to a field of solar cell technologies, and in particular, to a device and a method for turning a cell over.

### BACKGROUND

For a coating process of a heterojunction solar cell, a vacuum coating device such as PVD, CVD and so on is usually used. In a process of double-sided coating of the cell, the cell is required to be coated on one single side in the coating device, and then is turned over and re-enters into the coating device to be coated on the other side.

In the prior art, a cell is laid on a carrier board by manual or automatic loading, and the carrier board is delivered into a process chamber through a charge platform by an automatic delivery mechanism to perform a front surface coating of the cell, and the carrier board is delivered to a discharge platform from the process chamber after the front surface coating is completed; the cell is turned over manually or collected through an automatic discharge platform into a cell cassette, and after all the cells in the cell cassette are coated on their front surfaces, the cell cassette is flipped to turn over all the cells in the cell cassette with back surfaces facing upward, and the cells are laid on the carrier board manually or through the an automatic loading mechanism, and then are re-delivered into the process chamber to be coated on the other sides; after the coating on back surfaces of the cells are completed, the cells are unloaded manually or through the automatic unloading mechanism, thereby completing the double-sided coating of the cells.

However, the manner in the prior art in which the cells are manually turned over would lead to a low work efficiency and a high misoperation rate, accompanied by problems such as a reduced production pace and a high breakage rate of the cells; if automatic unloading is adopted, for example, using devices such as a multi-joint manipulator to unload the cells and load them again after the cells are turned over as a whole, a complicated operation process will be rendered. The overall process requires two cycles of loading and unloading of the cells, which will reduce work efficiency and retard the production process, and also lead to a problem of increasing the breakage rate of the cells.

### SUMMARY

In view of above, the present disclosure provides a device and a method for turning a cell over to solve the above existing problems in the prior art, simplify the turnover process, improve the production efficiency and reduce the breakage rate of the cell.

The present disclosure provides a device for turning a cell over, comprising: a turnover mechanism comprising a first gantry that is slidably disposed, wherein the first gantry is configured to pick up and turn over a cell; and a loading mechanism comprising a second gantry that is slidably disposed, wherein the second gantry is configured to pick up and load the cell that is turned over by the first gantry.

According to one aspect of the present disclosure, the first gantry comprises a first support beam, a transmission arm and a first pick-up mechanism, the transmission arm is rotatably connected to the first support beam, and the first pick-up mechanism is rotatably connected to the transmission arm.

According to one aspect of the present disclosure, a servo motor is provided at a conjunction between the transmission arm and the first support beam and a conjunction between the transmission arm and the first pick-up mechanism respectively.

According to one aspect of the present disclosure, the first pick-up mechanism comprises a first lifting device and a first suction disk, one end of the first lifting device is rotatably connected to the transmission arm, and the other end of the first lifting device is connected to the first suction disk.

According to one aspect of the present disclosure, the first lifting device is a first lifting cylinder, a cylinder body of the first lifting cylinder is rotatably connected to the transmission arm, and a piston rod of the first lifting cylinder is connected to the first suction disk.

According to one aspect of the present disclosure, the first gantry further comprises a connecting beam which is fixedly connected to the piston rod of the first lifting cylinder; the first suction disk comprises a plurality of sets of first suction disks, and the plurality of sets of first suction disks are evenly distributed on the connecting beam.

According to one aspect of the present disclosure, the second gantry comprises a second support beam, a second lifting device and a second pick-up mechanism, the second lifting device is fixedly disposed on the second support beam, and the second pick-up mechanism is slidably connected to the second lifting device.

According to one aspect of the present disclosure, the second pick-up mechanism comprises a connecting bracket and a second suction disk, one end of the connecting bracket is connected to the second lifting device, and the other end of the connecting bracket is connected to the second suction disk.

According to one aspect of the present disclosure, the second lifting device comprises a servo motor, a lead screw and a stop bracket, and an output shaft of the servo motor is fixedly connected to the lead screw; the stop bracket is fixedly connected to the second support beam, the stop bracket is provided with a hollow cavity into which the lead screw extends, and a limit slot that is slidably connected to the connecting bracket is provided in a side wall of the stop bracket; one end of the connecting bracket is provided with a threaded hole that is fitted with the lead screw.

The present disclosure further provides a method for turning a cell over, comprising: providing a turnover mechanism, the turnover mechanism comprising a first gantry that is slidably disposed, the first gantry being configured to pick up and turn over a cell; and providing a loading mechanism, wherein the loading mechanism comprises a second gantry that is slidably disposed, and the second gantry is configured to pick up and load the cell that is turned over by the first gantry.

According to one aspect of the present disclosure, the first gantry comprises a first support beam, a transmission arm and a first pick-up mechanism which are sequentially connected, and after the cell is picked up by the first pick-up mechanism, the transmission arm is caused to be rotated relative to the first support beam and the first pick-up mechanism is caused to be rotated relative to the transmission arm so as to turn over the cell by 180 degrees.

According to one aspect of the present disclosure, after the cell is picked up and turned over by the first gantry, the second gantry is caused to be in contact with the first gantry to pick up the cell that is turned over by the first gantry.

According to one aspect of the present disclosure, after the cell that is turned over by the first gantry is picked up by the second gantry, the cell picked up is laid on a carrier board by the second gantry.

According to one aspect of the present disclosure, before the cell picked up is laid on the carrier board by the second gantry, the first gantry is caused to restore to a state before performing turnover.

According to one aspect of the present disclosure, a sliding direction of the second gantry is caused to be parallel to a sliding direction of the first gantry.

The device and the method for turning a cell over provided by the present disclosure has realized automation of turnover and laying of the cell through cooperation of the first gantry with the second gantry, and solved the problem of production efficiency being affected by manual turnover and laying desired in the prior art, meanwhile, realized timely turnover and laying of the cell on the carrier board, and the common turnover after the cells are collected into the cell cassette is not required, thereby simplifying the turnover process effectively and improving the production pace.

### BRIEF DESCRIPTION OF THE DRAWINGS

Specific implementations of the present disclosure will be further described detailedly below in connection with the accompanying drawings.
FIG. 1 is a top plan view showing a device for turning a cell over according to embodiments of the present disclosure;
FIG. 2 is a front view showing a first gantry;
FIG. 3 is a side view showing the first gantry;
FIG. 4 is a front view showing a second gantry;
FIG. 5 is a side view showing the second gantry;
FIG. 6 is a view showing a state of the first gantry before performing turnover;
FIG. 7 is a view showing a state of the first gantry after performing turnover;
FIG. 8 is a view showing a state in which the cell on the first gantry is picked up by the second gantry;
FIG. 9 is a view showing a state in which the cell is laid on the carrier board.

### DESCRIPTION OF THE REFERENCE SIGNS:

10- device for turning cell over; 20-turnover mechanism; 30-loading mechanism; 100-carrier board; 200-first gantry; 210-first support beam; 220-transmission arm; 230-first lifting device; 240-first suction disk; 250-connecting beam; 260-servo motor; 270-overhang portion; 280-first pick-up mechanism; 300-second gantry; 310-second support beam; 320-servo motor; 330-stop bracket; 340-second suction disk; 350-connecting bracket; 360-second lifting device; 370-second pick-up mechanism; 380-lead screw; 400-first slide rails; 500-second slide rails; 600-cell.

### DETAILED DESCRIPTION OF THE EMBODIMENTS

Embodiments of the present disclosure are described in detail below, and examples of the embodiments are illustrated in the drawings, wherein the same or similar reference numerals are used to refer to the same or similar elements or elements having the same or similar functions. The embodiments described below with reference to the accompanying drawings are intended to be illustrative only, and are not explained to be a restriction to the present disclosure.

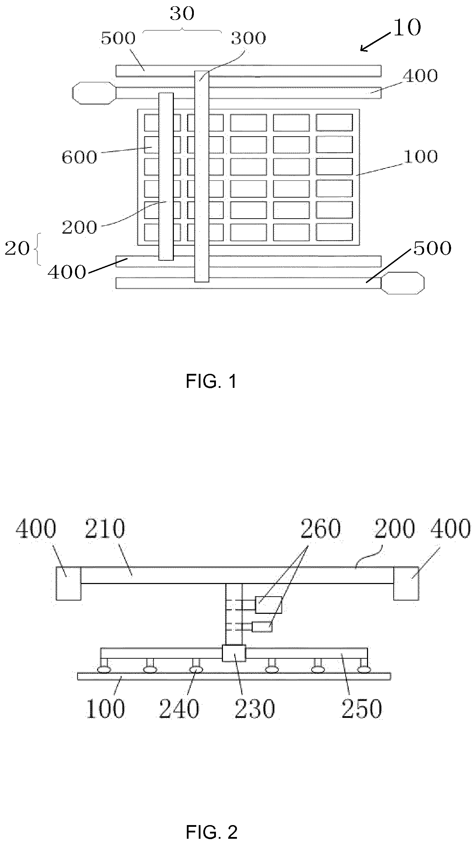

As shown in FIG. 1, the embodiments of the present disclosure provides a device 10 for turning a cell over, comprising a turnover mechanism 20 and a loading mechanism 30, wherein the turnover mechanism 20 comprises a first gantry 200 that is slidably disposed, and the first gantry 200 is configured to pick up and turn over a cell 600; wherein the loading mechanism 30 comprises a second gantry 300 that is slidably disposed, and the second gantry 300 is configured to pick up and load the cell 600 that is turned over by the first gantry 200 to lay the cell 600 turned over on a carrier board 100. For example, the cell 600 is a monocrstalline, polycrystalline or amorphous sheet made from semiconductor materials such as silicon, germanium and so on.

When the cell 600 is delivered to a preset position of a discharge platform or a conveyor belt after a front surface of the cell 600 is coated, the first gantry 200 picks up and turns over the cell 600, and the second gantry 300 picks up the cell 600 turned over when being in contact with the first gantry 200 and lays the sheet 600 turned over on the carrier board 100, and the carrier board 100 carrying the cell 600 turned over is delivered to a charge platform through an automatic delivery device for the cell 600 to be coated on a back surface. Therefore, the device 10 for turning the cell over has realized automation of turnover and laying of the cell 600, thereby solving the technical problem that the production efficiency is affected by manual turnover and laying of the cell desired in the prior art, and meanwhile realizing timely turnover and laying of the cell 600 on the carrier board 100, without collecting the cells 600 into the cell cassette together and turning them over as a whole, thereby simplifying the turnover process and improving the production pace.

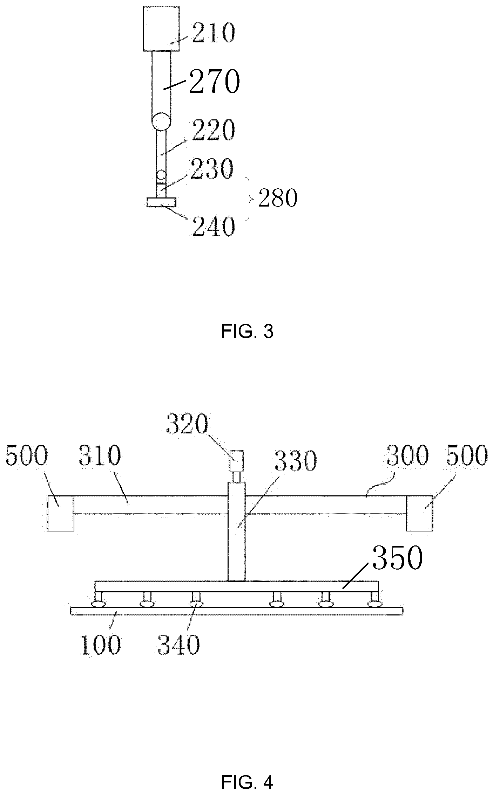

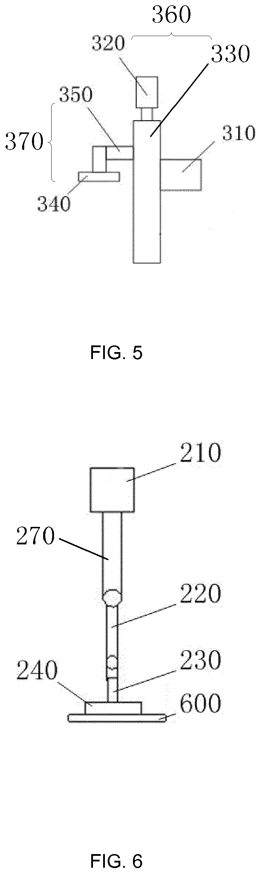

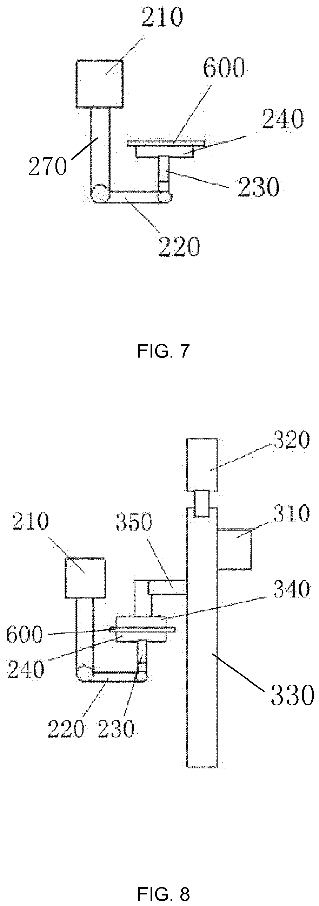

Referring to both FIG. 2 and FIG. 3, the first gantry 200 comprises a first support beam 210, a transmission arm 220 and a first pick-up mechanism 280, the first support beam 210 has an overhang portion 270 that overhangs vertically downward, the transmission arm 220 is rotatably connected to the overhang portion 270 of the first support beam 210, and the first pick-up mechanism 280 is rotatably connected to the transmission arm 220. As shown in FIG. 6, when the first gantry 200 moves to above the cell 600 to be picked up, the cell 600 may be picked up by the first pick-up mechanism 280; as shown in FIG. 7, after the cell 600 is picked up, the transmission arm 220 is rotated to a position perpendicular to the overhang portion 270 of the first support beam 210, meanwhile, the first pick-up mechanism 280 carrying the cell 600 is rotated to a position perpendicular to the transmission arm 220, thereby realizing the turnover of the cell 600 by 180 degrees to facilitate the picking-up of the second gantry 300.

In the present embodiment, the transmission arm 220 and the first pick-up mechanism 280 are controllable to rotate by a servo motor 260. Specifically, the servo motor 260 is disposed at a conjunction between the transmission arm 220 and the first support beam 210 (the overhang portion 270 of the first support beam 210) and a conjunction between the transmission arm 220 and the first pick-up mechanism 280 respectively, as shown in FIG. 2.

Specifically, referring to FIG. 3, the first pick-up mechanism 280 includes a first lifting device 230 and a first suction disk 240, one end of the first lifting device 230 is rotatably connected to the transmission arm 220, and the other end of the first lifting device 230 is connected to the first suction disk 240. Before picking up the cell 600 placed on the carrier board 100, the first gantry 200 maintains the state as shown in FIG. 3, at this time, the first lifting device 230 is controlled to push the first suction disk 240 to move so that the first suction disk 240 sucks up the cell 600, as shown in FIG. 6; in one embodiment, a vacuum pump and a sensor are disposed on the first gantry 200, and when the sensor detects that the first suction disk 240 is in contact with the cell 600, the vacuum pump is activated to cause the first suction disk 240 to suck up the cell 600.

Of course, the first pick-up mechanism may also include a mechanical clamp to achieve clamping and releasing of the cell 600 by controlling opening and closing of the clamp, but a clamping force of the mechanical clamp is not easy to be controlled, and thus the cell 600 is easy to be damaged; since the suction disk adopts a principle of controlling an air pressure to realize the picking-up of the cell 600, the cell 600 is not easy to be damaged but is easy to be controlled.

Specifically, the first lifting device 230 is a first lifting cylinder, a cylinder body of the first lifting cylinder is rotatably connected to the transmission arm 220, and a piston rod of the first lifting cylinder is connected to the first suction disk 240.

Further, as shown in FIG. 2, the first gantry 200 further includes a connecting beam 250 which is fixedly connected with the piston rod of the first lifting cylinder; the first suction disk 240 comprises a plurality of sets of first suction disks, and the plurality of sets of first suction disks 240 are evenly distributed on the connecting beam 250.

It should be noted that a plurality of laying regions for laying the cells 600 are provided on the carrier board 100, as shown in FIG. 1, and in the embodiment, the number of the laying regions is thirty arranged in six rows and five columns, hence, thirty cells 600 can be coated simultaneously; the connecting beam 250 may be a transverse beam, and in the embodiment, the connecting beam 250 is provided with six first suction disks 240 each corresponding to one laying region, thereby simultaneously turning the cells 600 over in the same column, thereby effectively improving the production efficiency.

It should be understood that the laying regions for the cells may be in any number, as long as it does not hinder the turning-over and loading operations of the cells. For example, the number of the laying regions is 4×5=20, 6 X 6 = 36, 5×8 =40,6×7=42 and so on.

Specifically, as shown in FIG. 1, the turnover mechanism 20 further includes first slide rails 400 disposed on both sides of the first gantry 200, and the first gantry 200 is slidably connected to the first slide rails 400. For example, two first slide rails 400 are symmetrically disposed in parallel with each other on both sides of the first gantry 200.

Usually, the carrier board 100 is placed right below the first gantry 200. At this time, laying regions in each column of the carrier board 100 are parallel to the first gantry 200, and after the cells 600 in laying regions of the first column are turned over, the first gantry 200 may slide along the first rails 400 to the next column of laying regions, thereby facilitating movement and control of the first gantry 200.

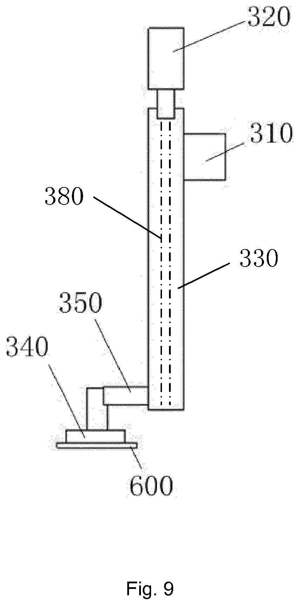

Further, referring to FIG. 4 and FIG. 5, the second gantry 300 includes a second support beam 310, a second lifting device 360 and a second pick-up mechanism 370. The second lifting device 360 is fixedly disposed on the second supporting beam 310, and the second pick-up mechanism 370 is slidably connected to the second lifting device 360. After the cell 600 is turned over by the first gantry 200, the second pick-up mechanism 370 is controlled by the second lifting device 360 to be in contact with the first suction disk 240 and pick up the cell 600 on the first suction disk 240, as shown in FIG. 8; then, the first gantry 200 is controlled to restore to a state before performing turnover so as to prevent the movement of the second pick-up mechanism 370 carrying the cell 600 from being blocked; after the first gantry 200 restores to the state before performing turnover, the second pick-up mechanism 370 is controlled by the second lifting device 360 to move in a direction toward the carrier 100 so as to lay the cell 600 turned over on the carrier board 100, as shown in FIG. 9; after the laying is completed, the second pick-up mechanism 370 is controlled to return to a position before picking up the cell 600, and the second gantry 300 and the first gantry 200 are controlled to move to a position of the next column of cells to be turned over, thereby realizing continuous turning-over and laying of the cells 600.

Specifically, as shown in FIG. 5, the second pick-up mechanism 370 includes a connecting bracket 350 and a second suction disk 340. One end of the connecting bracket 350 is connected to the second lifting device 360, and the other end of the connecting bracket 350 is connected to the second suction disk 340. Wherein, the connecting bracket 350 and the second suction disk 340 can be rotatably connected to each other to adjust an angle of the second suction disk 340 so that the second suction disk 340 is in contact fit with the first suction disk 240; certainly, the connecting bracket 350 and the second suction disk 340 can also be fixedly connected to each other to ensure the stability of a position of the second suction disk 340. Specific connection manner ought to meet the requirements of the contact fit between the second suction disk 340 and the first suction disk 240, which is not limited in this embodiment.

In one embodiment, a vacuum pump and a sensor may be disposed on the second gantry 300, and when the sensor detects that the second gantry 300 abuts against the first gantry 200 (namely, the second suction disk 340 abuts against the first suction disk 240), the vacuum pump is activated to cause the second suction disk 340 to suck up the cell 600 that is turned over by the first suction disk 240.

Further, as shown in FIG. 5, the second lifting device includes a servo motor 320, a stop bracket 330 and a lead screw 380, an output shaft of the servo motor 320 is fixedly connected to the lead screw 380; the stop bracket 330 is fixedly connected to the second support beam 310, the stop bracket 330 is provided with a hollow cavity into which the lead screw extends, and a limit slot that is slidably connected to the connecting bracket 330 is disposed in a sidewall of the stop bracket 330; one end of the connecting bracket 350 is provided with a thread hole that is fitted with the lead screw 380. When the servo motor 320 is activated, the lead screw 380 can be driven by the output shaft of the servo motor 320 to rotate. Since the connecting bracket 350 is in screwed connection with the lead screw 380, the connecting bracket 350 is movable in an axial direction of the lead screw 380; wherein the one end of the connecting bracket 350 that is provided with the threaded hole is slidably fitted with the limit slot, thereby preventing the second suction disk 340 from excessively moving while ensuring the accuracy of the movement of the second suction disk 340.

Of course, the number and the arrangement position of the second suction disk 340 correspond to those of the first suction disk 240 and thereby the turning-over and laying of the cell 600 can be achieved via the contact fit between the first suction disk 240 and the second suction disk 340.

It can be understood that, as shown in FIG. 1, in order to facilitate the movement and control of the second gantry 300, the loading mechanism 30 may further include second slide rails 500 disposed on both sides of the second gantry 300, and the second gantry 300 is slidably connected to the second slide rails 500. For example, two second slide rails 500 are symmetrically disposed in parallel with each other on both sides of the second gantry 300.

In one embodiment, in order to reduce interference and ensure abutment, a direction in which the second rails 500 extend (the sliding direction of the second gantry 300) is parallel to a direction in which the first rails 400 extend (the sliding direction of the first gantry 200).

It should be emphasized that the first slide rails 400 as shown in FIG. 1 are disposed on an inner side of the second slide rails 500, however, in the case that the picking-up, turning-over and loading of the cell are not affected, the slide rails 400 can also be disposed on an outer side of the second slide rails 500.

The present disclosure further provides a method for turning a cell over, comprising: providing a turnover mechanism 20, the turnover mechanism 20 comprising a first gantry that is slidably disposed, the first gantry being configured to pick up and turn over a cell 600; and providing a loading mechanism 30, wherein the loading mechanism 30 comprises a second gantry 300 that is slidably disposed, and the loading mechanism 30 is configured to pick up and load the cell 600 that is turned over by the first gantry 200.

In the method for turning a cell over according to the present disclosure, the first gantry 200 comprises a first support beam 210, a transmission arm 220 and a first pick-up mechanism 280 which are sequentially connected, and after the cell 600 is picked up by the first pick-up mechanism 280, the transmission arm 220 is caused to be rotated relative to the first support beam 210 and the first pick-up mechanism 280 is caused to be rotated relative to the transmission arm 220 so as to turn over the cell 600 by 180 degrees.

In the method for turning a cell over according to the present disclosure, after the cell 600 is picked up and turned over by the first gantry 200, the second gantry 300 is caused to abut against the first gantry 200 to pick up the cell 600 that is picked up by the first gantry 200.

In the method for turning a cell over according to the present disclosure, after the cell 600 that is turned over by the first gantry 200 is picked up by the second gantry 300, the cell 600 turned over is laid on a carrier board 100 by the second gantry 300.

In the method for turning a cell over according to the present disclosure, before the cell 600 picked up is laid on the carrier board 100 by the second gantry 300, the first gantry 200 is caused to restore to a state before performing turnover.

In the method of turning a cell over according to the present disclosure, a sliding direction of the second gantry 300 is caused to be parallel to a sliding direction of the first gantry 200.

The device and the method for turning a cell over provided by the present disclosure has realized automation of turnover and laying of the cell via the contact fitting between the first gantry and the second gantry, and solved the problem of the production efficiency being affected by manual turnover and laying of the cell desired in the prior art, and meanwhile realizing timely turnover and laying of the cell on the carrier board, and it is not required to collect the cells into the cell cassette together and turn them over as a whole, thereby effectively simplifying the turnover process and improving the production pace.

The structures, features and effects of the present disclosure have been described in detail above based on the embodiments as shown in the drawings. The above description is given only for preferred embodiments of the present disclosure, however, the present disclosure is not intended to limit the scope of the embodiments as shown in the drawings. The modifications made in accordance with the concept of the present disclosure, or equivalents to the modifications still fall within the scope of the present disclosure without departing from the spirit of the present disclosure.

## Claims

1. A device (10) for turning a cell over, comprising:
a turnover mechanism (20) comprising a first gantry (200) that is slidably disposed, the first gantry (200) being configured to pick up and turn over a cell (600); and
a loading mechanism (30) comprising a second gantry (300) that is slidably disposed, wherein the second gantry (300) is configured to pick up and load the cell (600) that is turned over by the first gantry (200).

2. The device (10) for turning a cell over according to claim 1, wherein the first gantry (200) comprises a first support beam (210), a transmission arm (220) and a first pick-up mechanism (280), the transmission arm (220) is rotatably connected to the first support beam (210), and the first pick-up mechanism (280) is rotatably connected to the transmission arm (220).

3. The device (10) for turning a cell over according to claim 2, wherein a servo motor (260) is provided at a conjunction between the transmission arm (220) and the first support beam (210) and a conjunction between the transmission arm (220) and the first pick-up mechanism (280) respectively.

4. The device (10) for turning a cell over according to claim 2, wherein the first pick-up mechanism (280) comprises a first lifting device (230) and a first suction disk (240), one end of the first lifting device (230) is rotatably connected to the transmission arm (220), and the other end of the first lifting device (230) is connected to the first suction disk (240).

5. The device (10) for turning a cell over according to claim 4, wherein the first lifting device (230) is a first lifting cylinder, a cylinder body of the first lifting cylinder is rotatably connected to the transmission arm (220), and a piston rod of the first lifting cylinder is connected to the first suction disk (240).

6. The device (10) for turning a cell over according to claim 5, wherein the first gantry (200) further comprises a connecting beam (250) which is fixedly connected to the piston rod of the first lifting cylinder;
wherein the first suction disk (240) comprises a plurality of sets of first suction disks, and the plurality of sets of first suction disks (240) are evenly distributed on the connecting beam (250).

7. The device (10) for turning a cell over according to claim 1, wherein the second gantry (300) comprises a second support beam (310), a second lifting device (360) and a second pick-up mechanism (370), the second lifting device (360) is fixedly disposed on the second support beam (310), and the second pick-up mechanism (370) is slidably connected to the second lifting device (360).

8. The device (10) for turning a cell over according to claim 7, wherein the second pick-up mechanism (370) comprises a connecting bracket (350) and a second suction disk (340), one end of the connecting bracket (350) is connected to the second lifting device (360), and the other end of the connecting bracket (350) is connected to the second suction disk (340).

9. The device (10) for turning a cell over according to claim 8, wherein the second lifting device (360) comprises a servo motor (320), a lead screw (380) and a stop bracket (330), and an output shaft of the servo motor (320) is fixedly connected to the lead screw (380);
wherein the stop bracket (330) is fixedly connected to the second support beam (310), the stop bracket (330) is provided with a hollow cavity into which the lead screw (380) extends, and a limit slot that is slidably connected to the connecting bracket (350) is provided in a side wall of the stop bracket (330);
wherein one end of the connecting bracket (350) is provided with a threaded hole that is fitted with the lead screw (380).

10. A method for turning a cell over, comprising:
providing a turnover mechanism (20) which comprises a first gantry (200) that is slidably disposed, the first gantry (200) being configured to pick up and turn over a cell (600); and
providing a loading mechanism (30), wherein the loading mechanism (30) comprises a second gantry (300) that is slidably disposed, and the second gantry (300) is configured to pick up and load the cell (600) that is turned over by the first gantry (200).

11. The method for turning a cell over according to claim 10, wherein the first gantry (200) comprises a first support beam (210), a transmission arm (220) and a first pick-up mechanism (280) which are sequentially connected, and after the cell (600) is picked up by the first pick-up mechanism (280), the transmission arm (220) is caused to be rotated relative to the first support beam (210) and the first pick-up mechanism (280) is caused to be rotated relative to the transmission arm (220) so as to turn over the cell (600) by 180 degrees.

12. The method for turning a cell over according to claim 11, wherein, after the cell (600) is picked up and turned over by the first gantry (200), the second gantry (300) is caused to abut against the first gantry (200) to pick up the cell (600) that is turned over by the first gantry (200).

13. The method for turning a cell over according to claim 12, wherein, after the cell (600) that is turned over by the first gantry (200) is picked up by the second gantry (300), the cell (600) picked up is laid on a carrier board (100) by the second gantry (300).

14. The method for turning a cell over according to claim 13, wherein, before the cell (600) picked up is laid on the carrier board (100) by the second gantry (300), the first gantry (200) is caused to restore to a state before performing turnover.

15. The method for turning a cell over according to any one of claims 10 to 14, wherein a sliding direction of the second gantry (300) is caused to be parallel to a sliding direction of the first gantry (200).
